# EUROPÄISCHE PATENTSCHRIFT

(11) **EP 2 203 955 B1**
(45) Veröffentlichungstag und Bekanntmachung des Hinweises auf die Patenterteilung: **20.07.2016**
(21) Anmeldenummer: 08842456.9
(22) Anmeldetag: 24.10.2008
(51) Int. Cl.: G01S 7/03, H05K 1/02, H05K 1/03, H05K 3/46, H01Q 1/38, H01Q 9/04

(54) **HERSTELLUNGSVERFAHREN FÜR EINEN RADARSENSOR**
PRODUCTION METHOD FOR A RADAR SENSOR
PROCÉDÉ DE FABRICATION D'UN DÉTECTEUR RADAR

(30) Priorität: 26.10.2007 DE 102007051318
(43) Veröffentlichungstag der Anmeldung: 07.07.2010
(73) Patentinhaber: Airbus Defence and Space GmbH, 85521 Ottobrunn (DE)
(72) Erfinder: KÖRBER, Richard, 91352 Hallerndorf (DE); BITTNER, Achim, 96224 Burgkundstadt (DE); SCHMID, Ulrich, 1140 Wien (AT); PRECHTEL, Ulrich, 81739 München (DE); ZIEGLER, Volker, 85579 Neubiberg (DE); FEURER, Ernst, 89134 Blaustein (DE)
(74) Vertreter: Kastel, Stefan
(86) Internationale Anmeldenummer: PCT/EP2008/064431
(87) Internationale Veröffentlichungsnummer: WO 2009/053460

(56) Entgegenhaltungen:
- EP-A- 0 450 773
- EP-A- 1 990 331
- WO-A-02/09232
- WO-A-99/22404
- JP-A- 1 135 106
- US-A1- 2006 137 173
- US-A1- 2006 256 016

## Beschreibung

Die Erfindung betrifft ein Verfahren zum Herstellen eines Radarsensors, der mehrere unterschiedlich ansteuerbare Antennen und ein Verteilnetzwerk zur Ansteuerung der Antennen aufweist.

Es gibt eine Vielzahl von Dokumenten aus dem Stand der Technik, die Vorrichtungen zum Abstrahlen elektromagnetischer Wellen oder unterschiedlichste Ausführungsformen von Radarsensoren offenbaren. Der Trägerkörper ist oftmals ein Mehrschichtkörper mit Materialschichten aus Glaskeramik. Die Antenne ist entweder in oder auf dem Mehrschichtkörper integriert bzw. angeordnet. Es ist aus diesen Druckschriften auch bereits bekannt, dass durch eine Reduzierung der effektiven Dielektrizitätszahl im Bereich der Antenne ein erhöhter Antennengewinn erzielbar ist.

Millimeterwellen-Radarsensoren, z.B. für automobile Anwendungen sollten eine kompakte und kostengünstige Bauweise vorweisen. Gleichzeitig ist eine optimale Systemempfindlichkeit erstrebenswert. Die Aufgabe des Sensors kann beispielsweise darin bestehen, den Nahbereich eines Kraftfahrzeugs mit Hilfe einer elektronisch schwenkbaren Antenne zu überwachen.

Weiterhin können Radarsensoren in der Luftfahrt z.B. zur Detektion von Wirbelschleppen verwendet werden. Die dazu bekannten Systeme sind große, bodengestützte Sensoren, die auf optischen, akustischen oder hochfrequenten elektromagnetischen Prinzipien beruhen.

Radarsensoren werden oft mit planaren Antennenelementen in einer Mehrlagenkeramik, die ein Substrat bildet, ausgeführt. Im Bereich der planaren Antennenelemente auf dem Substrat ist eine möglichst niedrige Dielektrizitätszahl erstrebenswert, um die Konzentration der Feldlinien im Substrat zu reduzieren und damit die Ablösung der elektromagnetischen Welle zu erleichtern.

Die US 2006/0137173 A1 offenbart ein einlagiges Substrat, in das mittels Sandstrahlen Kavitäten eingebracht werden, die einen zweiten Werkstoff aufnehmen können. Kavitäten unterschiedlicher Form und Größe werden durch Verwendung unterschiedlicher Masken und Variation der Bearbeitungszeiten erreicht.

Aus der EP 0450 773 A2 ist ein Verfahren zur Herstellung eines Materialiengemischs bekannt. Das erhaltene Materialiengemisch weist günstige Eigenschaften zur Verwendung in Gehäusen von integrierten Schaltungen auf.

Die LTCC (Low Temperature Cofired Ceramics) Technologie, eine bekannte keramische Mehrlagentechnik für Hochfrequenzanwendungen, bietet den Vorteil, durch Integration von passiven elektronischen Bauteilen in den Keramikkörper ein kompaktes, hochintegriertes Substrat bereitzustellen. Jedoch ist die hohe Dielektrizitätszahl von 7-8 nur im Bereich des Verteilnetzwerkes von Vorteil.

Zur Herstellung eines Radarsensors mit einem derartigen Bereich mit niedriger Dielektrizitätszahl finden sich im Stand der Technik verschiedene Ansätze.

Die DE 100 42 653 A1 schlägt vor, Tapes mit niedrigerer Dielektrizitätszahl in einen LTCC-Körper einzubringen.

Die US 5 859 614 A zeigt ein planares Antennenmodul zur Anwendung im Mikrowellenbereich, bei dem zur Reduzierung der Permittivität eine Kaptonfolie über eine LTCC-Kavität gespannt wird.

Aus der DE 10 2004 058 862 A1 ist eine Gruppenstrahlerantenne bekannt, die eine nicht-planare Trägerstruktur aus dielektrischem Material aufweist. Es wird ein Herstellverfahren für diese Gruppenstrahlerantenne beschrieben, bei der die Trägerstruktur in LTCC-Technik gefertigt wird, wobei darauf Antennenpatches aufgebracht werden. Aufgrund der hohen Dielektrizitätszahl der keramischen Trägerstruktur ist der Antennengewinn sehr gering.

Aus der DE 103 34 429 A1 ist eine Sende-/Empfangsvorrichtung mit einer Antenne bekannt, die auf einem mehrschichtigen Trägerkörper aufgebracht ist. Die die Antenne unmittelbar tragende Materialschicht, die aus dem keramischen Trägerkörpermaterial gebildet ist, weist unterhalb der Antenne mehrere derart verteilte Ausnehmungen auf, dass eine elektrische Eigenschaft, beispielsweise der dielektrische Verlust, entlang einer Ausdehnung einen Gradienten aufweist. Diese Ausnehmungen sind bei einer Ausgestaltung mit einem Füllstoff befüllt, der eine andere elektrische Eigenschaft als das Trägerkörpermaterial aufweist. Als Beispiel für das Trägerkörpermaterial ist Glaskeramik angegeben. In den Ausnehmungen in der Materialschicht aus Trägerkörpermaterial ist ein organischer Füllstoff, also ein im Wesentlichen homogenes Material, eingesetzt.

Aus der WO 99/22404 A1 ist ein Verfahren zum Herstellen eines Radarsensors bekannt, bei dem in Kavitäten, die in einem Trägerkörpermaterial eingebracht sind, ein Füllstoff aus einem organischen Material eingebracht wird.

Aus der US 2006/0256016 A1 ist eine integrierte Millimeter-Vllellen-Planar-Array-Antenne mit einem Verteilnetzwerk bekannt, bei der Antennenpatches auf einem LTCC-Substrat aus mehreren Schichten aufgebracht sind.

Ideal wäre, im Bereich der Antennen reine Kavitäten und somit Vakuum oder Luft zu haben, um so aus den eingangs erwähnten Gründen eine möglichst geringe Dielektrizitätszahl im Bereich der Antenne zu erhalten. Die Antenne muss aber auch exakt getragen und abgestützt werden, wozu Vakuum und Luft natürlich ungeeignet sind. Daher geht man im Stand der Technik den Weg der mit organischem Füllmaterial befüllten Kavitäten. Dieses Füllmaterial bietet eine Basis zum Stützen der Antennen. Jedoch ist die Minimierung der Dielektrizitätszahl auf diejenige des verwendeten Füllmaterials begrenzt.

Der Erfindung liegt die Aufgabe zugrunde, ein verbessertes Herstellungsverfahren für einen vielseitig verwendbaren Radarsensor vorzuschlagen.

Zur Lösung dieser Aufgabe wird ein Verfahren gemäß Patentanspruch 1 vorgeschlagen.

Vorteilhafte Ausgestaltungen der Erfindung sind Gegenstand der Unteransprüche.

Die Erfindung schafft ein Verfahren zum Herstellen eines Radarsensors, der mehrere unterschiedlich ansteuerbare Antennen und ein Verteilnetzwerk zur Ansteuerung der Antennen aufweist,
gekennzeichnet durch
a) Bereitstellen einer keramischen Trägerstruktur mit dem Verteilnetzwerk, in welcher Kavitäten ausgebildet werden,
b) Befüllen der Kavitäten mit einer Materialmatrix aus einem von der Keramik der Trägerstruktur verschiedenen ersten Material mit Einschlüssen aus einem zweiten Material, um innerhalb der Materialmatrix eine Vielzahl von Bereichen auszubilden, die eine niedrigere Dielektrizitätszahl als das erste Material aufweisen, wobei als das erste Material Polyimid verwendet wird, und
c) Aufbringen planarer Antennenpatches auf die Materialmatrix,
   wobei Schritt b) wenigstens einen der Schritte enthält:
   b1) dass zum Bilden der Materialmatrix Mikrohohlkugeln in das erste Material eingebettet werden, die die Bereiche mit niedriger Dielektrizitätszahl bilden;
   b2) dass dem ersten Material ein in dem ersten Material nicht lösbares Pulver beigegeben wird, das in einem weiteren Arbeitsschritt mittels nasschemischen Ätzens aus dem ersten Material gelöst wird;
   b3) dass die Materialmatrix in einem Sol-Gel-Prozess hergestellt wird; oder
   b4) dass die Materialmatrix als poröse Schicht ausgebildet wird.

Das erfindungsgemäße Verfahren bietet den Vorteil, dass auf einfache Art und Weise ein Trägermaterial mit einer niedrigen Dielektrizitätskonstante im Bereich der Antennenelemente aufgebracht werden kann. Das Verfahren vereinfacht insbesondere die Herstellung von Radarsensoren mit einer Vielzahl von Antennenelementen, da es schnell und in gleichbleibender Qualität durchführbar ist.

Als Füllmaterial wird erfindungsgemäß nicht einfach ein homogenes organisches Material verwendet, vielmehr wird zum Befüllen der Kavitäten ein Materialmix aus einer Materialmatrix, also einem Materialgerüst, aus einem ersten Material, das bereits eine niedrige Dielektrizitätszahl aufweist und unterschiedlich zur Keramik der Trägerstruktur ist, und aus einem darin eingeschlossenen oder eingebetteten zweiten Material verwendet. Diese Einschlüsse dienen dazu, an den Stellen der Einschlüsse eine noch geringere Dielektrizitätszahl als das erste Material zu bilden.

Dies kann auf unterschiedliche Weise geschehen. Bei einer Ausgestaltung wird das zweite Material, das selbst eine niedrigere Dielektrizitätskonstante aufweist, innerhalb der Materialmatrix eingeschlossen. Bei einer zweiten Variante wird ein zweites Material verwendet, welches später, z.B. nach einem Aushärten oder im Zuge eines Aushärtens einer aus aushärtbarem erstem Material gebildeten Materialmatrix, aus dieser Materialmatrix entfernbar ist, so dass an den Stellen der Einschlüsse Luft oder Vakuum entsteht, um somit Stellen mit besonders niedriger Dielektrizitätszahl auszubilden.

Bei dem erfindungsgemäßen Verfahren kann die Materialmatrix die Kavität derart ausfüllen, dass darauf Elemente, wie insbesondere Antennen, tragend abgestützt aufgebracht werden können. Innerhalb der Materialmatrix aus diesem ersten Material gibt es aber weiter noch Einschlüsse mit Bereichen geringerer Dielektrizität, was insgesamt die Dielektrizitätszahl des aus Materialmatrix mit Einschlüssen gebildeten Hüllmaterials verringert.

Somit kann bei einfacher Herstellweise eine gute Antennenbasis mit geringerer Dielektrizitätszahl als bei den bisher bekannten Verfüllungen von Kavitäten erreicht werden.

Ein Vorteil der Erfindung liegt in der Möglichkeit, in einem Schritt eine Vielzahl von Antennenpatches herzustellen, wobei unterhalb der Elemente Material mit besonders niedrigerer Dielektrizitätskonstante angeordnet ist. Dadurch sind vergleichbar zu der Herstellung integrierter Schaltungen eine Vielzahl von Baukomponenten in einem gemeinsamen Herstellverfahren herstellbar. Dies ist insbesondere bei dem Aufbau eines Antennenfelds mit unterschiedlich ansteuerbaren Antennen zwecks Scannen eines Sichtfeldes mittels eines Radarsensors vorteilhaft, der insbesondere elektrisch und nicht mechanisch geschwenkt werden kann.

Die Antennenpatches können unmittelbar auf die Materialmatrix aufgebracht werden. Dies erlaubt, insbesondere wenn die Materialmatrix mit der keramischen Trägerstruktur schließt, zur Verbindung der Antennenpatches auf eine konventionelle Bondverbindung zu verzichten, die durch ihre schlechten HF-Eigenschaften die Qualität der Abstrahlung verschlechtern würde.

Vorteilhaft wird zum Durchführen des Schritts a) die keramische Trägerstruktur aus einer Niedertemperatur-Einbrand-Keramik (LTCC) hergestellt. LTCC weist eine verhältnismäßig hohe Permittivität auf, die für die Aufnahme von Steuerleitungen, Verteilnetzwerken und elektronischen Bauelementen in Hochfrequenzschaltungen vorteilhaft ist. Des Weiteren isoliert diese hohe Permittivität hochfrequente elektromagnetische Felder in den Steuerleitungen und verhindert ein Übersprechen. Schließlich ist die Herstellung von LTCC in Mehrlagentechnik gut bekannt und zuverlässig durchführbar. Durch die Möglichkeit, die die LTCC-Technik bietet, wie zum Beispiel die Integration von passiven elektronischen Bauelementen im Keramikkörper, ist eine äußerst kompakte Ausführungsform auch sehr komplexer Radarsensoren möglich.

Als erstes Material wird erfindungsgemäß ein organisches Material verwendet, nämlich Polyimid, welches eine für Hochfrequenzantennen günstige Permittivität aufweist. Dieses lässt sich durch Verwendung des zweiten Materials noch weiter strukturieren, um es beispielsweise porös auszugestalten, um so die Permittivität weiter zu senken und den Antennengewinn weiter zu erhöhen.

Der Schritt b) kann Einfüllen zumindest des ersten Materials in fließfähigem Zustand und Aushärten des Matrixmaterials umfassen. Die Verwendung von fließfähigem Material macht eine vorherige Größenanpassung, die bei derart kleinen Strukturen aufwändig, aber beispielsweise bei Verwendung einer Kaptonfolie notwendig ist, überflüssig. Des Weiteren können Kavitäten unterschiedlicher Größe einfach befüllt werden. Dies ist insbesondere zum Bereitstellen eines Verfahrens für einen hochintegrierten Radarsensor sehr vorteilhaft.

Gemäß einer Variante der Erfindung werden zum Bilden der Materialmatrix Mikrohohlkugeln in das erste Material eingebettet, die die Bereiche mit niedriger Dielektrizitätszahl bilden. Diese Mikrohohlkugeln bieten die Möglichkeit, Material niedriger Dielektrizitätszahl, insbesondere Luft oder ein anderes Gas oder auch Luft/Gas geringeren Drucks (je näher am Vakuum desto besser), in die Materialmatrix einzubringen, ohne dass sich dieses mit dem ersten Material vermischen oder mit diesem reagieren könnte. Dadurch erweitert sich die Auswahl möglicher Materialien beträchtlich.

Bei einer weiteren Variante der Erfindung wird dem ersten Material ein in dem ersten Material nicht lösbares Pulver beigegeben, das in einem weiteren Arbeitsschritt mittels nasschemischen Ätzens aus dem ersten Material gelöst wird. Durch Gestaltung der Korngröße und der Form der Körnchen des Pulvers können die Eigenschaften der Materialmatrix einfach und kostengünstig eingestellt werden.

Bei einer weiteren Variante der Erfindung kann die Materialmatrix in einem Sol-Gel-Prozess hergestellt werden. Dieser Prozess kann eine sehr widerstandsfähige Materialmatrix mit geringer Permittivität bilden.

Gemäß einer weiteren Variante der Erfindung kann Schritt b) das Ausbilden der Materialmatrix als poröse Schicht aufweisen. Dies erlaubt es, einen großen Anteil der Materialmatrix mit Materialien niedriger Permittivität, insbesondere Luft, zu füllen.

Vorteilhaft ist das erste Material photostrukturierbar. Bevorzugt werden die Strukturen des ersten Materials unter Verwendung eines Lithographieprozesses aufgebracht. Dadurch können insbesondere Radarsensoren mit einer Vielzahl von Antennenelementen schnell und kostengünstig gefertigt werden.

In vorteilhafter Ausgestaltung werden in oder an der Trägerstruktur integrierte Signalleitungen, Masseleitungen, passive elektronische Bauelemente, wärmeleitende Schichten und/oder Phasenschieberelemente ausgebildet. Dadurch kann der Radarsensor als integrales Bauteil ohne wesentliche äußere Beschaltung ausgebildet werden, was den Einbau in unterschiedliche, technische Systeme erleichtert.

Ausführungsbeispiele der Erfindung werden nachfolgend anhand der beigefügten Zeichnungen näher beschrieben. Es zeigen im Einzelnen:
- Fig. 1: eine Draufsicht auf einen Radarsensor, der mit einem hier vorgestellten Verfahren herstellbar ist, wobei der Radarsensor eine Vielzahl von Radarantennenelementen aufweist;
- Fig. 2a: eine Schnittdarstellung einer ersten Ausführungsform eines Radarantennenelements, das ein Antennenpatch, ein Substrat und eine Materialmatrix als Tragschicht für das Antennenpatch aufweist;
- Fig. 2b: eine Schnittdarstellung einer zweiten Ausführungsform eines solchen Radarantennenelements;
- Fig. 3: eine Mikroskopvergrößerung einer als Tragschicht verwendbaren Materialmatrix mit Mikrohohlkugeln;
- Fig. 4: eine noch weiter vergrößerte Ansicht wie in Fig. 3;
- Fig. 5a: ein Beispiel von Spinkurven für reines Polyimid;
- Fig. 5b: ein Beispiel von Spinkurven für Polyimid mit Mikroglashohlkugeln;
- Fig. 5c: eine Grafik mit Angaben zur mittleren Rauhtiefe von Polyimid;
- Fig. 6: eine vergrößerte Ansicht von Polyimid mit darin dispergiertem Pulver;
- Fig. 7: eine vergrößerte Ansicht eines porosizierten Bereichs eines Polyimids; und
- Fig. 8: ein Schema eines Sol-Gel-Prozesses.

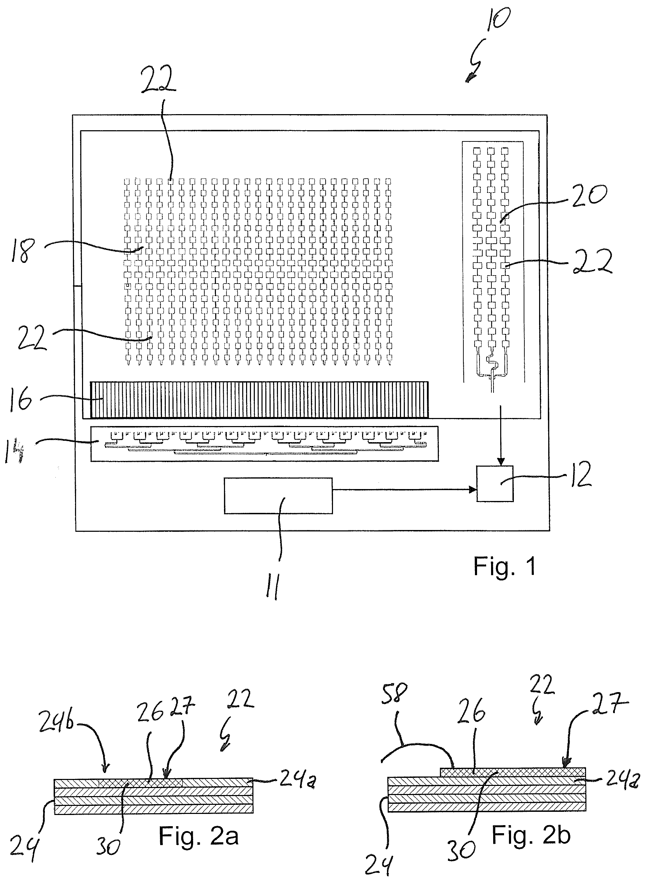

Fig. 1 zeigt den prinzipiellen Aufbau eines Radarsensors 10, der mit einem hier besonders interessierenden Verfahren realisierbar ist. Der Radarsensor 10 weist eine Sendeelektronik 11, eine Empfangselektronik 12, ein Verteilnetzwerk 14, Phasenschieber 16 zur elektronischen Strahlschwenkung sowie eine planare Antennenstruktur als Sendeantenneneinheit 18 zum Senden und eine planare Antennenstruktur als Empfangsantenneneinheit 20 zum Empfangen von elektromagnetischen Wellen auf.

Die Sendeantenneneinheit 18 und die Empfangsantenneneinheit 20 weisen jeweils eine Mehrzahl von Radarantennenelementen 22 auf.

Der Strahl der Sendeantenneneinheit 18 ist mit Hilfe der Phasenschieber 16 elektronisch schwenkbar, so dass bei hoher Ortsauflösung (3°x5°) ein weiter Detektionsbereich (± 10°) realisiert wird.

Der gesamte Radarsensor 10 ist auf einer ca. 1 mm dicken mehrlagigen Glaskeramik untergebracht, so dass die im Automobilbereich gewünschte geringe Bautiefe erzielt wird.

Der Aufbau der Radarantennenelemente 22 kann auf verschiedene Weisen gestaltet werden.

So ist beispielsweise ein Aufbau wie in Fig. 2a möglich, bei dem die oberste Schicht 24a eines mehrlagigen Substrats 24 eine Kavität 24b aufweist. Gemäß der Ausführung von Fig. 2a ist in die Kavität 24b eine Materialmatrix 30 als Teil einer Tragschicht 26 eingearbeitet. Auf der Tragschicht ist ein Antennenpatch 27 aufgebracht.

In alternativer Ausbildung, wie in Fig. 2b gezeigt, kann die die Materialmatrix 30 aufweisende und das Antennenpatch 27 tragende Tragschicht 26 auf die oberste Schicht 24a aufgesetzt ausgebildet sein.

Um den Radarsensor 10 mit einer Vielzahl elektrischer Signalleitungen realisieren zu können, sind eine hohe Integrationsdichte, sowie möglichst geringe ohmsche sowie dielektrische Verluste wünschenswert. Diese Anforderungen machen die Verwendung einer Mehrlagenglaskeramik LTCC (low temperature cofired ceramic) als Trägersubstrat vorteilhaft, da sie beispielsweise die Realisierung von niederohmigen Vias auf Silberbasis ermöglicht, die zudem mit hoher Designfreiheit in dem keramischen Grundkörper angeordnet werden können.

Ferner ist es für einen optimierten Betrieb des Radarsensors 10 wünschenswert, auf dem Trägerbereich lokal Bereiche mit unterschiedlichen dielektrischen Eigenschaften zu erzeugen. Im Bereich der Antennenpatches 27 ist eine geringere Dielektrizitätszahl (εr < 3) und ein geringer Verlustfaktor als im Bereich des Verteilnetzwerks 14 erwünscht, um eine möglichst effiziente Abstrahlung und Ablösung der auszusendenden elektromagnetischen Wellen zu realisieren. Da LTCC im Bereich Er = 7 bis 8 liegt, ist die Verwendung von Materialkombinationen vorteilhaft, insbesondere wenn ein Radarsensor 10 im Bereich sehr hoher Frequenzen von z.B. 79 GHz angestrebt wird.

In Bereichen außerhalb der Antennenpatches 27 hingegen ist ein hohes εr anzustreben, da Abstrahlungen von den Leitungsstrukturen insbesondere von dem Verteilnetzwerk 14 unerwünscht sind. Diese unterschiedlichen Anforderungen sind daher bevorzugt mit einer Materialkombination aus LTCC und weiteren Materialien zu erzielen.

Neben der Verwendung des LTCC-Substrates sollen daher im Folgenden verschiedene Verfahren und Materialien vorgestellt werden, mit denen die genannten Anforderungen erreicht werden können. Weiterhin werden neuartige Verfahren zur Reduktion der Permeabilität im Antennenbereich sowie die Integration dieser Bereiche in eine Multilayer-Glaskeramik vorgestellt.

Eine in der Hochfrequenztechnik bereits verwendete Materialgruppe sind Polyimide. Polyimide haben typischerweise ein εr von 3 bis 3,5 und sind in der Regel als flüssige Precursoren erhältlich. Diese können mit Standardprozessen aus der Mikrosystemtechnik verarbeitet werden und so entweder mittels Spin-on-Technik (z.B. Spin-Coating-Verfahren wie aus der Halbleiterproduktionstechnik zum Beschichten unter Einsatz von Zentrifugalkräften bekannt) auf das Substrat 24 aufgebracht werden, oder in eine Kavität 24b gefüllt werden. Falls diese Polyimide eine photosensitive Komponente enthalten, können sie ferner mit Hilfe lithographischer Verfahren strukturiert werden.

Das Füllen von Kavitäten 24b funktioniert entweder durch Aufspinnen, oder durch Dispensen in die Kavitäten 24b. Vorteil des Füllens der Kavitäten 24b ist, dass der Materialübergang keine Stufe auf der Oberfläche verursacht (siehe Fig. 2a). Dadurch ist es möglich, die Metallisierung z.B. zum Kontaktieren der Antennenpatches 27 direkt über diesen Materialübergang hinweg zu realisieren. Durch die Stufe im Konzept "Polyimid auf LTCC" (siehe Fig. 2b) ist eine Drahtverbindung 58 zwischen Substrat 24 und dem Antennenpatch 27, das auf der Polyimidschicht angeordnet ist, notwendig. Diese Drahtverbindung 58 verursacht eine ungewünschte Dämpfung des Signals, da sie insbesondere bei hohen Frequenzen eine Induktivität darstellt.

Um die Dielektrizitätskonstante des Polyimids weiter zu senken, werden in einer ersten Ausführungsform des erfindungsgemäßen Verfahrens Additive in dem Precursor dispergiert und/oder eingebracht. Besonders Mikrohohlkugeln 28 aus Glas sind für diesen Zweck geeignet. Die Glaswand der Mikrohohlkugeln 28 hat eine Dielektrizitätszahl εr von etwa 2 bis 2,5, wobei die Dielektrizitätszahl der gesamten Mikrohohlkugeln 28 durch die eingeschlossene Luft (εr=1) noch wesentlich gesenkt wird. Durch das Einbringen von Mikrohohlkugeln 28 in eine Materialmatrix 30 aus Polyimid ergibt sich somit eine effektive Dielektrizitätszahl, die unter der des reinen Polyimids liegt.

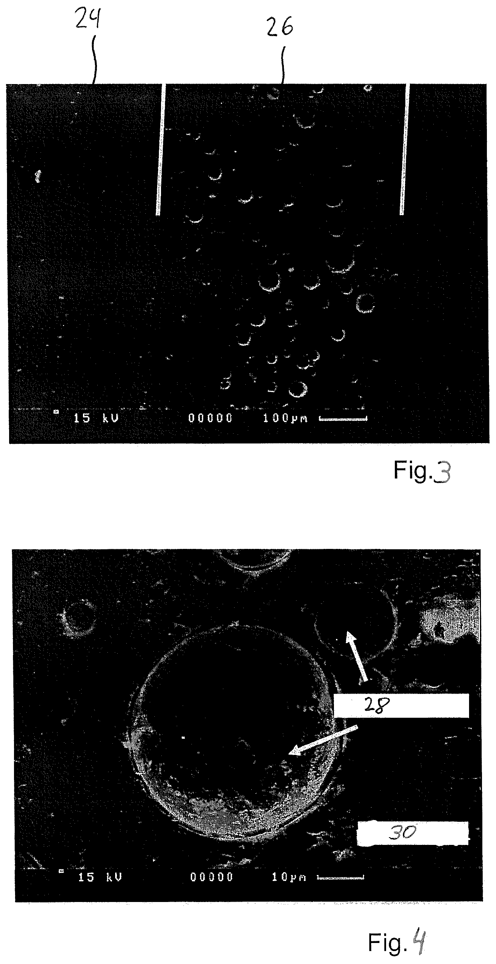

Wie aus Fig. 3 und 4 ersichtlich, ist eine erfolgreiche Applizierung dieser Kombination auf ein Substrat 24, hier aus LTCC, technologisch machbar.

Ein weiterer Vorteil der sich aus der Verwendung derartiger Füllstoffe in dem Polymer ergibt, ist eine erhöhte Schichtdicke 32. Um einen nachhaltigen Effekt zu erzielen, sind für die Anwendung des Radarantennenelements bei 79 GHz Schichtdicken 32 von etwa 30 bis 100µm vorteilhaft. Diese Schichtdicken 32 sind mit reinem Polyimid nur durch mehrfaches Auftragen mittels Spin-On-Technik realisierbar, was im Sinne einer hohen Reproduzierbarkeit von Schichtparametern technologisch schwierig umzusetzen ist.

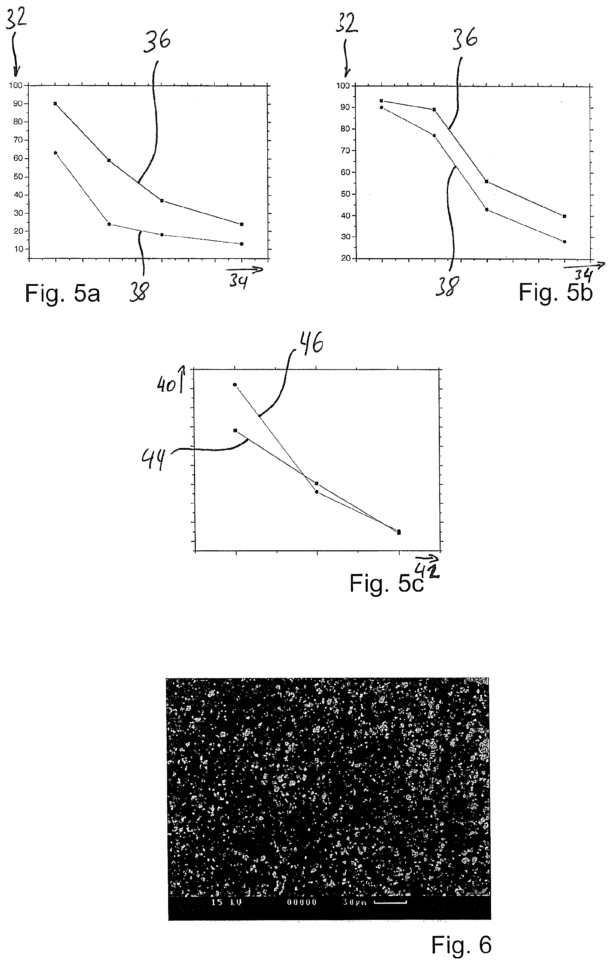

Ein Vergleich der erzielbaren Schichtdicken 32 bei verschiedenen Spingeschwindigkeiten 34 ist in den Fig. 5a und 5b gezeigt, wobei jeweils eine Kurve die Schichtdicke 32 nach dem Hardbake (Kurve 38) und nach dem Softbake (Kurve 36) angibt. Ein Vergleich der Kurven 36, 38 zeigt, dass durch Zugabe des Füllstoffs die erzielbare Schichtdicke 32 ansteigt, wodurch die Schichtdickenvorgabe für eine technisch relevante Aufgabenstellung erfüllt werden kann.

Durch die Glashohlkugeln mit einem maximalen Durchmesser von etwa 40 µm steigt die Rauhigkeit 40 der Polyimidoberfläche an (siehe Fig. 5c), wodurch die minimalen Strukturabmessungen, die auf der Oberfläche, beispielsweise an Metallisierungsschichten, erreicht werden können, größer werden. Die Rauhigkeit 40 kann jedoch durch Überspinnen mit einer Schicht aus reinem Polyimid wieder gesenkt werden, so dass eine für Dünnschichttechnik geeignete Oberflächencharakteristik erzeugt werden kann.

In Fig. 5c ist die Rauhigkeit 40 der Polyimidoberfläche abhängig von der Schichtenanzahl 42 gezeigt, wobei jeweils ein Messwert für eine Oberfläche ohne Schicht, mit einer Schicht und mit zwei Schichten angegeben ist. Daraus ergeben sich zwei Kurven: Eine erste Kurve 44, die die Rauhigkeit 40 für ein Verhältnis der Gewichtsanteile von Glashohlkugeln zu Polyimidmatrix von 1:10 und eine zweite Kurve 46, die die Rauhigkeit 40 für ein Verhältnis der Gewichtsanteile von 1:7,5 angibt.

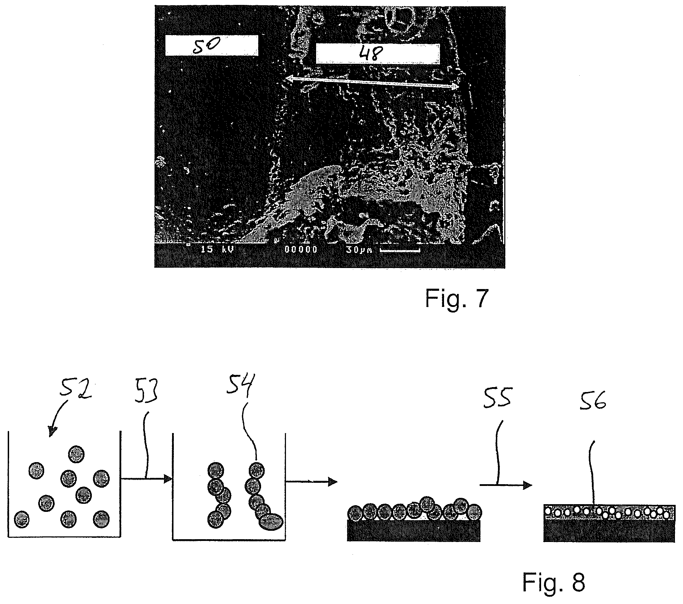

Eine weitere Ausgestaltung des erfindungsgemäßen Verfahrens stellt der folgende Ansatz zum Reduzieren der Dielektrizitätszahl von reinem Polyimid dar: In ein Polyimid wird ein Pulver (beispielsweise aus Aluminiumoxid (Al2O3) oder Aluminiumnitird (AIN)) mit einem mittleren Korndurchmesser von beispielsweise 10 µm dispergiert (siehe Fig. 6) und anschließend diese Materialkombination in eine LTCC-Kavität gefüllt. Anschließend wird über einen nasschemischen Ätzschritt der Füller, also das Al2O3 oder AIN, wieder herausgelöst, so dass eine mikroporöse Struktur in dem Polyimid entsteht. Wichtig hierfür ist eine hohe Selektivität zwischen Füller und Polyimid. Ferner muss eine ausreichend homogene Verteilung des dispergierten Füllermaterials sichergestellt werden. In Vorversuchen konnte dieses Verfahren mit Hilfe einer phosphorsäure-basierten Ätzlösung und der oben genannten Kombination erfolgreich durchgeführt werden. Zusätzlich wäre es wünschenswert, dass die entsprechende Ätzlösung die LTCC-Keramik nicht angreift. Falls doch, muss in diesen Bereichen durch eine entsprechende Maskierung dieser unerwünschte Effekt verhindert werden. Der in Fig. 7 gezeigte Querschnitt durch eine porösizierte AIN/Polyimid Oberfläche zeigt entsprechend einen porösizierten Bereich 48 und einen Bereich aus AIN in Polyimid 50.

In einer weiteren Ausführungsform werden poröse Sol-Gel-Schichten zur Ausbildung der Tragschicht 26 verwendet.

Ein Sol-Gel-Prozess ist beispielhaft in Fig. 8 dargestellt. Aus einem flüssig verarbeitbaren Sol 52 entsteht dabei durch Vernetzung 53 eine Gelschicht 54, aus der bei der Kalzinierung 55 eine mikroporöse Siliziumoxidschicht 56 entsteht. Reines SiO2 hat eine Dielektrizitätszahl von ca εr = 2, was wiederum durch die Porosität auf einen Wert deutlich unter 2 gesenkt werden kann. Als geeignetes Material bietet sich beispielsweise Tetraethylorthosilan (TEOS) an, welches mit Wasser und Ethanol zur gewünschten Gelschicht 54 reagiert, die auf das Substrat 24 aufgeschleudert wird.

Anschließend wird es bei Temperaturen von T < 700°C kalziniert, wobei sich das Gel in reines SiO2 umwandelt. Diese Temperaturen treten auch bei sogenannten "Post Firing Schritten" im Bereich der LTCC-Technologie auf, falls nach dem eigentlichen Sintervorgang für den keramischen Grundkörper passive Strukturen (beispielsweise Widerstände) in Dickschichttechnik realisiert werden sollen. Daher ist dieser Hochtemperaturschritt mit dem LTCC-Material kompatibel.

Es sind auch weitere Materialien zur Erzeugung einer derartigen porösen Struktur mit einem flüssig einfüllbaren Matrixmaterial möglich, hierzu wird lediglich ein erstes Material durch Einschlüsse eines zweiten Materials mit Bereichen niedrigerer Dielektrizitätszahl versehen.

In Bereich von planaren Antennenpatches 27 auf einem Substrat 24 ist lokal eine möglichst niedrige Dielektrizitätskonstante vorteilhaft, um die Konzentration der Feldlinien im Substrat zu reduzieren und damit die Ablösung der elektromagnetischen Welle zu erleichtern.

Durch die Befüllung von Kavitäten 24b in einem LTCC-Substrat 24 mit Material niedriger Dielektrizitätszahl oder lokal begrenzter Applizierung dieses Materials direkt auf der Oberfläche kann der bestehende Prozess zur Herstellung des LTCC-Körpers beibehalten werden und trotzdem lokal ein Bereich mit niedriger Dielektrizitätszahl geschaffen werden. Durch geeignetes Befüllen mit flüssigem, organischem Material wird die Möglichkeit gegeben, über beide Bereiche eine Dünnfilmmetallisierung zu führen, die die planaren Antennenpatches 27 elektrisch kontaktiert. Dies ist insbesondere bei hohen Frequenzen im Bereich von 79 bis 81 GHz sehr vorteilhaft, da die Verwendung von Bonddrähten auf eine minimale Anzahl beschränkt wird.

Im Bereich der planaren Antennenpatches 27 ist zur verbesserten Ablösung der elektromagnetischen Wellen eine erniedrigte Dielektrizitätszahl und im Bereich des Verteilnetzwerkes 14 eine möglichst hohe Dielektrizitätszahl vorteilhaft. In beiden Bereichen sollte jedoch der Verlustwinkel möglichst gering sein.

Für den luftfahrtbezogenen Nischenmarkt könnte eine erhöhte Sicherheit während des Start- und Landevorgangs erzielt werden, falls Wirbelschleppen, die an den Flügeln des vorausfliegenden Flugzeuges entstehen, auf der Landebahn lokalisiert werden könnten. Ferner könnte eine erhöhte Start- und Landefrequenz erreicht werden. Bisherige Systeme zur Wirbelschleppenerkennung sind große, bodengestützte Sensoren, die auf optischen, akustischen oder hochfrequenten elektromagnetischen Prinzipien beruhen. Ein weiterführender Ansatz ist die bordgestütze Erkennung der Wirbelschleppen, die in letzter Konsequenz aktiv in die Flugregelung eingreifen soll, um den Einfluss der Verwirbelungen auf dem Flugweg zu minimieren. Derartige optische Systeme befinden sich gerade in der Erforschung, benötigen bei schlechtem Wetter jedoch ein komplementäres Radarsystem. Mit Hilfe einer elektronisch phasengesteuerten Antenne, beispielsweise in einem Radarsensor 10, könnte das Nahfeld vor dem Flugzeug mit ausreichender Schnelligkeit gescannt werden. Da vor allem kleinere Flugzeuge von dieser Thematik betroffen sind, sollte das Sensorsystem zusätzlich einen minimalen Einbauplatz benötigen und kostengünstig sein.

Der Radarsensor 10 ist bei 79 GHz für automobile Anwendungen mit einem weiten Detektionsbereich (± 10°) bei gleichzeitig schmaler Antennenkeule (3°x5°) einsetzbar. Weiterhin kann der Radarsensor 10 in einem Radar zur Erkennung von Wirbelschleppen bei Flugzeugen eingesetzt werden. Diese Aufgaben werden durch die elektronisch schwenkbare Sendeantenneneinheit 18 in hervorragendem Maße erfüllt. Für die automobile Anwendung ist der Sensor damit in der Lage, im mittleren Entfernungsbereich (30 bis 80 m) mehrere Fahrbahnen zu überwachen und gleichzeitig eine genaue Positionsbestimmung der detektierten Objekte durchzuführen. Er erfüllt ferner eine Vorwarn-Funktion für ein Short-Range Radar, welches eine Rundum-Überwachung des Fahrzeugs bis 30m Entfernung gewährleistet. Im Flugzeugbereich können Luftverwirbelungen auf und im Bereich der Start- und Landebahnen erkannt werden. Dies ermöglicht die aktive Ausregelung der Turbulenzen (Erhöhung des Flugkomforts). Ferner kann der Einfluss von vibrationsbedingter Materialermüdung reduziert werden.

Um eine wettbewerbsfähige Umsetzung des Radarsensors 10 bei zugleich geringem Bauteilvolumen sicherzustellen, wird ein hochintegrierter Gesamtaufbau aus einer Kombination aus keramischen und bevorzugt organischen Materialien unter Einsatz einer innovativen dünnfilmbasierten Aufbau- und Verbindungstechnik (AVT) vorgeschlagen. Die Phasensteuerung der Antenne wird durch die Verwendung neuartiger und kostengünstiger HF-MEMS-Schalter umgesetzt.

### Bezugszeichenliste

- 10: Radarsensor
- 11: Sendeelektronik
- 12: Empfangselektronik
- 14: Verteilnetzwerk
- 16: Phasenschieber
- 18: Sendeantenneneinheit
- 20: Empfangsantenneneinheit
- 22: Radarantennenelement
- 24: Substrat
- 24a: Schicht
- 24b: Kavität
- 26: Tragschicht
- 27: Antennenpatch
- 28: Mikrohohlkugeln
- 30: Materialmatrix
- 32: Schichtdicke
- 34: Spingeschwindigkeit
- 36: Kurve (Softbake)
- 38: Kurve (Hardbake)
- 40: Rauhigkeit
- 42: Schichtanzahl
- 44: erste Kurve (1:10)
- 46: zweite Kurve (1:7,5)
- 48: porösizierter Bereich
- 50: AIN in Polyamid
- 52: Sol
- 53: Vernetzung
- 54: Gelschicht
- 55: Kalzinierung
- 56: Siliziumoxidschicht
- 58: Drahtverbindung

## Patentansprüche

1. Verfahren zum Herstellen eines Radarsensors (10), der mehrere unterschiedlich ansteuerbare Antennen (18, 20) und ein Verteilnetzwerk (14) zur Ansteuerung der Antennen (18,20) aufweist,
**gekennzeichnet durch**
a) Bereitstellen einer keramischen Trägerstruktur mit dem Verteilnetzwerk (14), in welcher Kavitäten (24b) ausgebildet werden,
b) Befüllen der Kavitäten (24b) mit einer Materialmatrix (30) aus einem von der Keramik der Trägerstruktur verschiedenen ersten Material mit Einschlüssen aus einem zweiten Material, um innerhalb der Materialmatrix (30) eine Vielzahl von Bereichen auszubilden, die eine niedrigere Dielektrizitätszahl als das erste Material aufweisen, wobei als das erste Material Polyimid verwendet wird, und
c) Aufbringen planarer Antennenpatches (27) auf die Materialmatrix (30),
wobei Schritt b) wenigstens einen der Schritte enthält:
b1) dass zum Bilden der Materialmatrix (30) Mikrohohlkugeln (28) in das erste Material eingebettet werden, die die Bereiche mit niedriger Dielektrizitätszahl bilden;
b2) dass dem ersten Material ein in dem ersten Material nicht lösbares Pulver beigegeben wird, das in einem weiteren Arbeitsschritt mittels nasschemischen Ätzens aus dem ersten Material gelöst wird;
b3) dass die Materialmatrix (30) in einem Sol-Gel-Prozess hergestellt wird; oder
b4) dass die Materialmatrix (30) als poröse Schicht ausgebildet wird.

2. Verfahren nach einem der voranstehenden Ansprüche,
**dadurch gekennzeichnet, dass** die Antennenpatches (27) unmittelbar auf die Materialmatrix (30) aufgebracht werden.

3. Verfahren nach einem der voranstehenden Ansprüche,
**dadurch gekennzeichnet, dass** zum Durchführen des Schritts a) die keramische Trägerstruktur aus einer Niedertemperatur-Einbrand-Keramik (LTCC) hergestellt wird.

4. Verfahren nach einem der voranstehenden Ansprüche,
**dadurch gekennzeichnet, dass** Schritt b) umfasst: Einfüllen zumindest des ersten Materials in fließfähigem Zustand und Aushärten des Matrixmaterials.

5. Verfahren nach einem der voranstehenden Ansprüche,
**dadurch gekennzeichnet, dass** das erste Material photostrukturierbar ist und die Strukturen des ersten Materials unter Verwendung eines Lithographieprozesses aufgebracht werden.

6. Verfahren nach einem der voranstehenden Ansprüche,
**dadurch gekennzeichnet, dass** in oder an der Trägerstruktur integrierte Signalleitungen, Masseleitungen, passive elektronische Bauelemente, wärmeleitende Schichten und/oder Phasenschieber (16) ausgebildet werden.

## Claims

1. Production method for a radar sensor (10) that comprises several controllable antennas (18, 20) and a distribution network (14) for controlling said antennas (18, 20),
**characterized by**
a) providing a ceramic support structure having said distribution network (14) in which cavities (24b) are formed,
b) filling said cavities (24b) with a material matrix (30) of a first material different from said support structure and having inclusions of a second material for forming within said material matrix (30) a plurality of regions presenting a dielectric constant lower than that of the first material, wherein polyimide is used as the first material, and
c) applying planar antenna patches (27) onto said material matrix (30),
wherein step b) includes at least one of the steps in which:
b1) for forming said material matrix (30), small hollow microspheres (28) are embedded in said first material which form said regions presenting a low dielectric constant;
b2) a powder is added to said first material which does not dissolve in said first material and which is dislodged from the first material by a wet chemical etching process in a further working step;
b3) the material matrix (30) is prepared in a sol-gel process; or
b4) the material matrix (30) is formed as a porous layer.

2. Method according to any one of the preceding claims,
**characterized in that** said antenna patches (27) are directly applied onto said material matrix (30).

3. Method according to any one of the preceding claims,
**characterized in that** for performing step a), said ceramic support structure is prepared from low temperature cofired ceramics (LTCC).

4. Method according to any one of the preceding claims,
**characterized in that** step b) comprises: pouring in said at least first material in a flowable condition and curing the material matrix.

5. Method according to any one of the preceding claims,
**characterized in that** the first material is photopatternable and the patterns of the first material are applied using a lithography process.

6. Method according to any one of the preceding claims,
**characterized in that** integrated signal lines, earth wires, passive electronic components, heat conductive layers and/or phase shifters (16) are formed in or on said support structure.

## Revendications

1. Procédé pour la fabrication d'un détecteur radar (10) qui comprend plusieurs antennes (18, 20) susceptibles d'être pilotées différemment et un réseau distributeur (14) pour le pilotage des antennes (18, 20), **caractérisé par** les étapes consistant à
a) préparer une structure porteuse en céramique avec le réseau distributeur (14), dans laquelle sont ménagées des cavités (24b),
b) remplir les cavités (24b) avec un matériau de matrice (30) en un premier matériau différent de la céramique de la structure porteuse avec des inclusions d'un second matériau, afin de réaliser à l'intérieur du matériau de matrice (30) une pluralité de régions qui présentent un facteur de diélectricité plus faible que le premier matériau, dans lequel on utilise du polyimide à titre de premier matériau, et
c) application de patchs d'antenne planaires (27) sur le matériau de matrice (30),
dans lequel l'étape (b) contient l'une au moins des opérations suivantes :
b1) pour former le matériau de matrice (30) on inclut des microbilles creuses (28) dans le premier matériau, qui forment les régions avec facteur de diélectricité plus faible ;
b2) on ajoute au premier matériau une poudre qui n'est pas soluble dans le premier matériau et qui est dégagée hors du premier matériau dans une autre étape de travail au moyen d'une attaque chimique en voie humide ;
b3) le matériau de matrice (30) est produit dans un processus sol-gel ; ou
b4) le matériau de matrice (30) est réalisé comme une couche poreuse.

2. Procédé selon l'une des revendications précédentes,
**caractérisé en ce que** les patchs d'antenne (27) sont appliqués directement sur le matériau de matrice (30).

3. Procédé selon l'une des revendications précédentes,
**caractérisé en ce que** pour exécuter l'étape a) la structure porteuse en céramique est produite à partir d'une céramique cocuite à basse température (LTCC).

4. Procédé selon l'une des revendications précédentes,
**caractérisé en ce que** l'étape b) inclut : le remplissage au moins du premier matériau dans un état capable de s'écouler et le durcissement du matériau de matrice.

5. Procédé selon l'une des revendications précédentes,
**caractérisé en ce que** le premier matériau est capable d'être photo-structuré et les structures du premier matériau sont appliquées en utilisant un processus de lithographie.

6. Procédé selon l'une des revendications précédentes,
**caractérisé en ce que** des lignes pour les signaux, des lignes de masse, des composants électroniques passifs, des couches thermoconductrices et/ou des décaleurs de phase (16) sont réalisés de manière intégrée dans ou sur la structure porteuse.
